# EUROPEAN PATENT APPLICATION

(11) **EP 4 390 541 A1**
(43) Date of publication of application: **26.06.2024**
(21) Application number: 22216399.0
(22) Date of filing: 23.12.2022
(51) Int. Cl.: G03F 7/00, H01L 21/683

(54) **OBJECT TABLE**

(71) Applicant: ASML Netherlands B.V., 5500 AH Veldhoven (NL)
(72) Inventor: WARMING, Till, 5500 AH Veldhoven (NL)
(74) Representative: ASML Netherlands B.V.

(57) **Abstract**

An object table comprising an electrostatic clamp which comprises at least one electrode provided between insulating layers, and a second clamp which comprises an array of electrically connected burls, the burls comprising a layer of resistive material at an object receiving surface of the burls.

## Description

### FIELD

The present invention relates to an object table for clamping a an object such as a lithographic substrate. The object table may form part of a lithographic apparatus or lithographic tool.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A substrate which is being patterned by a lithographic apparatus is held on a substrate table. The substrate table includes a substrate clamp which is configured to securely hold the substrate on the substrate table whilst the substrate is being patterned, and then to allow the substrate to be removed from the substrate table once patterning has been completed. In an EUV system the substrate clamp is an electrical clamp (conventional vacuum clamps cannot be used because the EUV lithographic apparatus uses a vacuum environment). A problem which may arise in connection with electrical substrate clamps is that it may be difficult to ensure that the substrate is clamped sufficiently strongly to avoid slipping of the substrate during lithographic patterning, whilst at the same time avoiding excessive friction between the substrate table and the substrate.

In more detail, when the substrate is loaded onto the substrate table, with the clamp is switched off, the substrate should be able to settle on the substrate table and release any stress. The substrate table is provided with an array of burls, and the friction between the substrate and the burls should be sufficiently low to allow the substrate to relax to a stress-free state. If the substrate does not relax to a stress-free state, but instead remains stressed, then this may correspond with distortion of the substrate. This distortion may lead to poor quality patterns being formed on the substrate. Thus, low friction when the substrate clamp is switched off is desirable. When the substrate clamp is switched on, the substrate clamp pulls the substrate onto the burls thereby generating friction between the burls and the substrate. This friction should be sufficient that localized heating of the substrate, occurring during exposure of a pattern on the substrate, does not generate an expansive force which is sufficiently large to overcome the friction. In other words, when the substrate is heated during lithographic exposure, slippage of the substrate over the burls should not occur.

It may be desirable to address the above problem in a manner which is not disclosed or suggested by the prior art.

### SUMMARY

According to a first aspect of the invention there is provided an object table comprising an electrostatic clamp which comprises at least one electrode provided between insulating layers, and a second clamp which comprises an array of electrically connected burls, the burls comprising a layer of resistive material at an object receiving surface of the burls.

Advantageously, the electrostatic clamp provides initial clamping force which is sufficient to avoid slipping of an object on the object table, and the second clamp provides additional clamping force after the initial clamping force.

The second clamp may be a Johnsen-Rahbek type clamp.

The resistive material may be doped diamond.

The resistive material may be diamond doped with Boron.

The layer of resistive material may have a resistivity of at least 10⁶ Ohm cm.

The layer of resistive material may have a thickness of at least 100nm.

The electrostatic clamp may be provided with an array of openings. The burls may be formed from electrically conductive material which extends through the openings.

The burls may be integrally formed with an electrically conductive body, and wherein the electrostatic clamp is fixed to the electrically conductive body.

The electrically conductive body may be provided with annular recesses which surround the burls.

The electrically conductive body may comprise flat portions located between the burls, the flat portions receiving the electrostatic clamp.

Electrically conductive material may be provided on top of the electrostatic clamp, the electrically conductive material extending over the burls and electrically connecting the burls.

The electrostatic clamp may comprise two electrodes provided between insulating layers, the electrodes being electrically isolated from each other.

The Johnsen-Rahbek clamp may comprise two electrically conductive parts, the electrically conductive parts being electrically isolated from each other.

According to a second aspect of the invention there is provide a lithographic apparatus comprising an illumination system and a projection system, and further comprising an object table according to the first aspect of the invention.

The lithographic apparatus may be a dual stage lithographic apparatus with two (or more) object tables. The two object (or more) object tables may be according to the first aspect of the invention.

According to a third aspect of the invention there is provided a lithographic tool, wherein the lithographic tool further comprises an object table according to the first aspect of the invention.

According to a fourth aspect of the invention there is provided an object table comprising a first clamp configured to clamp an object using a first clamping mechanism and a second clamp configured to clamp an object using a second clamping mechanism.

Advantageously, the two different clamping mechanisms may be provide different clamping forces which may be applied at different times (e.g. one clamping force may be applied initially and one clamping force may be provided subsequently - such that both clamping forces are applied after a period of time).

According to a fifth aspect of the invention there is provided a lithographic method performed using a dual stage lithographic apparatus, the method comprising placing a substrate on a substrate table comprising an electrostatic clamp and a Johnsen-Rahbek clamp, supplying electrical power to the electrostatic clamp and the Johnsen-Rahbek clamp, moving the substrate table to a measurement system of a dual stage lithographic apparatus then measuring properties of the substrate whilst charge accumulates on the Johnsen-Rahbek clamp, and moving the substrate table to a projection system of the dual stage lithographic apparatus, and using the projection system to project a pattern onto the substrate.

Advantageously, advantageously, the electrostatic clamp provides initial clamping force which is sufficient to avoid slipping of the substrate on the substrate table during measurement of the substrate, and the Johnsen-Rahbek clamp provides additional force after the initial clamping force. The additional force applied by the Johnsen-Rahbek clamp may inhibit slippage of the substrate during lithographic exposure.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a substrate table according to an embodiment of the invention;
- Figure 2 schematically depicts part of the substrate table according to an embodiment of the invention in cross-section;
- Figure 3 schematically depicts the substrate table of Figure 2 viewed from above; and
- Figures 4A and 4B schematically depict respectively in cross-section and viewed from above, a substrate table according to an alternative embodiment of the invention.

### DETAILED DESCRIPTION

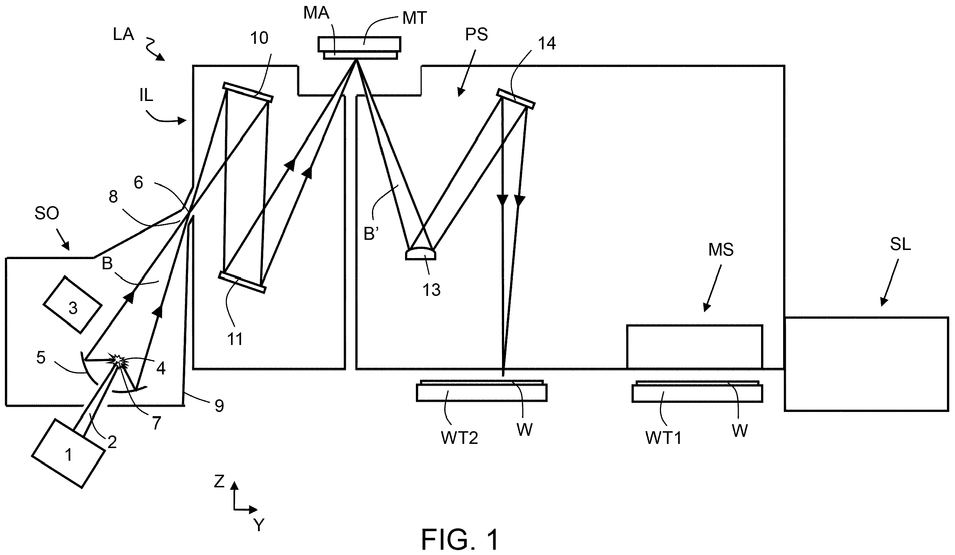

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS, a measurement system MS, and a substrate loading system SL. The lithographic system further comprises two substrate tables WT1, WT2 which are configured to support a substrate W. Each substrate table WT1, WT2 may be according to an embodiment of the invention. The support structure MT may be according to an embodiment of the invention. As explained further below, the substrate clamp may comprise an electrostatic clamp and a Johnsen-Rahbek clamp.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT2. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the environment of the projection system PS (which may also contain the measurement system MS).

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

The measurement system MS of the lithographic apparatus is configured to perform measurements of properties of a substrate W held on a substrate table WT1. The measurement system MS comprises an alignment system, which is configured to measure the positions of alignment marks on the substrate with reference to alignment marks on the substrate table WT1. The measurement system further comprises a level sensor which is configured to measure the topology of the substrate W. These measured properties are used to ensure accuracy when a pattern is subsequently projected onto the substrate W.

The lithographic apparatus LA is a dual-stage lithographic apparatus. That is, the lithographic apparatus includes two substrate tables WT1, WT2 and is configured such that a substrate W held on one of the substrate tables WT1 is measured by the measurement system MS simultaneously with a pattern being applied to a substrate W held on the other substrate table WT2. For ease of terminology, one of the substrate tables WT1 may be referred to as a first substrate table, and the other substrate table WT2 may be referred to as a second substrate table. Dual-stage lithographic apparatus advantageously provide higher throughput (i.e. exposure of substrates per hour) than single stage lithographic apparatus (which generally perform measurements simultaneously with exposure of a substrate). Once the substrate W held on the first substrate table WT1 has been measured, and the substrate W held on the second substrate table WT2 has been exposed, the substrate table WT1 supporting the measured substrate W is moved to be beneath the projection system PS. At the same time, the exposed substrate W supported by the second substrate table WT2 is moved to the substrate loading system SL.

The substrate loading system SL includes a substrate handler (not depicted) which is configured to remove the patterned substrate W from the second substrate table WT2, and then load a new substrate to be patterned onto the second substrate table. Once the substrate has been loaded onto the second substrate table WT2, the measurement system MS is used to measure alignment mark positions and the topology of the substrate. Simultaneously, the substrate W held on the first substrate table WT1 is exposed by the lithographic apparatus.

The above method is repeated many times in order to expose many substrates using the lithographic apparatus.

Each substrate table WT1, WT2 comprises a substrate clamp according to an embodiment of the invention. The substrate clamp is switched off before an exposed substrate is to be removed from the substrate table, thereby allowing a substrate handler of the substrate loading system to easily remove the substrate from the substrate table. An unexposed substrate is then placed on the substrate table WT1 (or WT2), following which the substrate clamp is switched on.

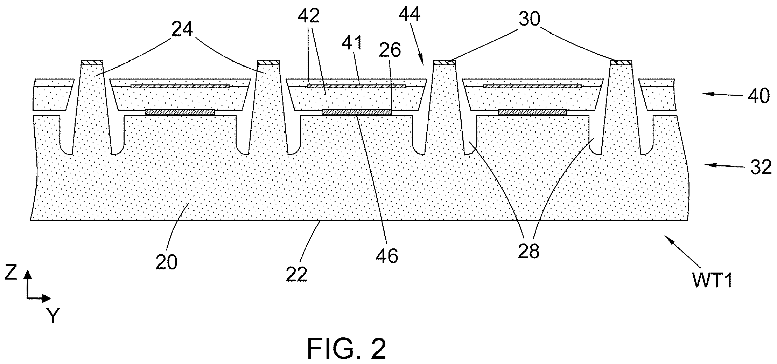

Figure 2 schematically depicts in cross section part of one of the substrate tables WT1 of Figure 1. The other substrate table WT2 may have the same construction. The substrate table WT1 comprises a base 20 with a flat lowermost surface 22. An array of burls 24 project upwardly from the base 20 (only some are labelled to avoid over-complicating Figure 2). In between the burls 24 the base 20 has a flat upper surface 26 (only one flat area is labelled to avoid over-complicating Figure 2). An annular recess 28 surrounds each burl 24, thereby providing separation between the burls and the flat upper surface area 26. This separation decreases the stiffness of the burls, making the burls more flexible. This in turn reduces a likelihood of thermal slip of a substrate on the burls (the burls can bend to accommodate some expansion of the substrate during exposure of the substrate).

The base 20 and burls 24 may be integrally formed from the same material. The material used to form the base 20 and the burls 24 is an electrical conductor, and may be silicon carbide, or some other conductive ceramic. The burls 24 are electrically connected via the base 20.

A layer of resistive material 30 is provided on the tip of each burl 24. The resistive material may for example be diamond which has been doped with Boron. Other dopants may be used. The dopant should increase the conductivity of the diamond (or other resistive material 30). The dopant may be provided at a concentration which provides the diamond (or other resistive material) with a resistivity between 10¹³ Ohm cm and 10⁶ Ohm cm. The dopant may be provided at a concentration which provides the diamond (or other resistive material) with a resistivity of around 10⁸ Ohm cm.

The base 20 of the substrate table WT1 is connected to a source of electrical current (not depicted). The source of electrical current is controlled by a controller (not depicted) which is configured to connect and disconnect the current source from the base 20 (and may apply a desired voltage to the base). When a substrate is present on the substrate table WT1, the current source may be connected to the base 20 on such that current is supplied to the base (and a voltage is applied to the base). Because the base 20 is a conductor, charge may flow through the base easily. Due to a voltage difference between the substrate W and the base 20, some current will flow through the resistive layer 30 on each burl 24. As a result, charge may accumulate on the upper surface of each resistive layer 30. This charge will give rise to the Johnsen-Rahbek clamping effect, thereby clamping the substrate to the substrate table WT1. Thus, the base 20, burls 24 and resistive layers 30 form a Johnsen-Rahbek clamp 32.

The substrate table WT1 further comprises an electrostatic clamp 40. The electrostatic clamp comprises an electrode 41 which is sandwiched between two layers of dielectric 42. The electrode 41 and dielectric 42 include openings 44 through which the burls 24 project. The dielectric may for example be glass, sapphire or silica. The electrode may for example be formed from chromium, aluminium or any coated metal layer. The electrostatic clamp 40 may be secured to the base 20 by adhesive 46.

The substrate table WT1 thus comprises a Johnsen-Rahbek clamp 32 and an electrostatic clamp 40.

The substrate table WT1 may include further layers, such as a support layer (not depicted).

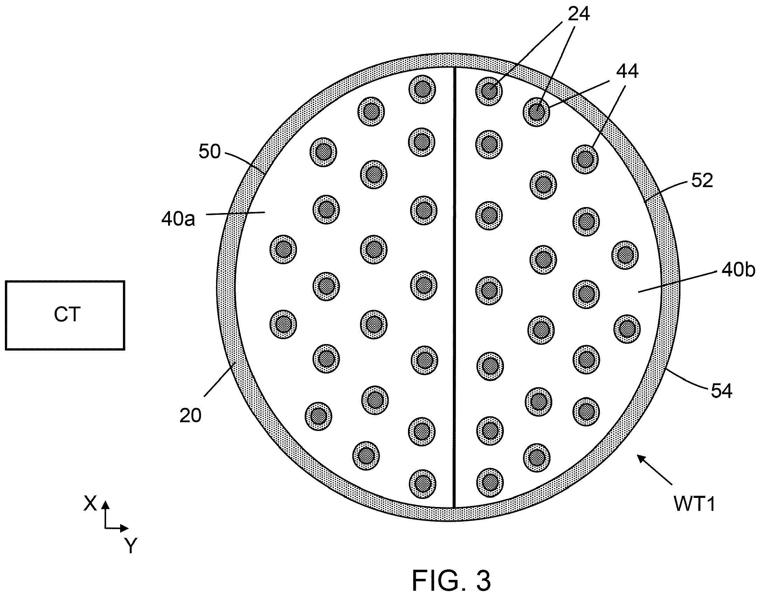

Figure 3 schematically depicts the substrate table WT1 viewed from above. As may be seen, the substrate table WT1 comprises the base 20 and first and second parts 40a,b of the electrostatic clamp. A first half 40a of the electrostatic clamp is generally semi-circular. Openings 44 through which burls 24 project may be seen. The openings and the burls are schematically depicted, and in practice there may be many more burls than depicted, with the burls (and openings) being significantly smaller than schematically depicted. In an embodiment, the burls may have a diameter at an upper end of around 200 microns. The openings may have a diameter of around 600 microns. The burls may be separated by around 1.5mm. The substrate table WT1 may have a diameter of around 300 mm. These are merely example dimensions, and other dimensions may be used.

A voltage source 50 is connected to the first half 40a of the electrostatic clamp 40, and is configured to apply a voltage to the first half of the electrostatic clamp. The second half of the electrostatic clamp 40b is also semi-circular, and is located adjacent to, but not in electrical contact with, the first half of the electrostatic clamp. A voltage source 52 is connected to the second half of the electrostatic clamp 40b and is configured to apply a voltage to the electrostatic clamp. The voltage sources 50, 52 may be configured to apply voltages of opposite polarities to the two halves 40a, 40b of the electrostatic clamp. This is desirable because it may avoid or reduce a general build-up of electrostatic charge on a substrate which is being supported by the substrate table WT1. A source of electrical current 54 is connected to the base 20. The current source 54 may be an amplifier that controls both current and voltage. The voltage and current sources 50, 52, 54 may all be controlled by a controller CT. Although the electrical sources 50, 52, 54 and the controller CT are depicted as being separate from the substrate table WT1, in practice they may all be located within the substrate table.

The Johnsen-Rahbek clamp 21 and the electrostatic clamp 40 are electrically isolated from each other. Specifically, the electrode 41 of the electrostatic clamp 40 does not contact the base 20 or the burls 24 (as may be seen from Figure 2). This allows the electrostatic clamp 40 and the Johnsen-Rahbek clamp 32 to be operated independently of each other.

Use according to an embodiment of the invention is now described with reference to Figures 1 to 3. A substrate W is loaded onto the first substrate table WT1. The electrostatic clamp 40 is switched on and clamps the substrate to the first substrate table WT1. Clamping force is applied by the electrostatic clamp 40 instantaneously. The Johnsen-Rahbek clamp 32 is also switched on. However, unlike the electrostatic clamp 40, the Johnsen-Rahbek clamp 32 takes a significant time to establish a clamping force which is applied to the substrate. In the case of the electrostatic clamp 40, the voltage which is applied to the first and second parts 40a, 40b is applied effectively instantaneously and thus clamps the substrate immediately when voltage sources 50, 52 are connected to the electrodes 40a, 40b. However, in the case of the Johnsen-Rahbek clamp 32, significant time is needed to allow charge to flow through the base 20 and across the resistive layers 30. It is the accumulation of charge at the upper most surfaces of the resistive layers 30 which provides the Johnsen-Rahbek clamping effect.

However, the significant time before clamping force is applied by the Johnsen-Rahbek clamp is not problematic, because the substrate W supported by the first substrate table WT1 is not exposed immediately after the substrate is placed on the substrate table. Instead, as explained further above, properties of the substrate W are measured by the measurement system MS. This measurement by the measurement system MS takes some time, typically several seconds, and this provides sufficient time for the Johnsen-Rahbek clamping force to be fully established. In an example, the Johnsen-Rahbek force may be fully established within around 1 second. Thus, advantageously, the electrostatic clamp provides initial clamping force which is sufficient to avoid slipping of the substrate W on the first substrate table WT1 during measurement of the substrate.

Once measurement of the substrate W on the first substrate table WT1 has been completed, and lithographic exposure of a substrate W on the second substrate table WT2 has been completed, the first substrate table WT1 is moved to be beneath the projection system PS. At the same time, the second substrate table WT2 is moved to the substrate loading system SL. Lithographic exposure of the substrate W on the first substrate table WT1 commences. By the time exposure of the substrate W on the first substrate table WT1 commences, the Johnsen-Rahbek force has been fully established by the Johnsen-Rahbek clamp 32. Thus, heating of the substrate W during exposure, which could lead to expansion of the substrate and slippage over the burls if only electrostatic clamping force was applied, does not lead to expansion and slippage due to the clamping force applied by the Johnsen-Rahbek clamp 32.

Once exposure of the substrate W has been completed, the first substrate table WT1 passes back from beneath the projection system PS to the substrate loading system SL. As soon as exposure of the substrate has been completed, the Johnsen-Rahbek clamp 32 may be switched off (i.e. the current source 54, which may be an amplifier that controls current and voltage, may be set to 0V), as a result of which charge will migrate back through the resistive layers 30 and dissipate within the base 20.

The electrostatic clamp 40 may be switched off (e.g. set to 0V) when the substrate table WT1 has arrived at the substrate loading system SL. The charge at the upper surfaces of the resistive layers 30 may have dissipated sufficiently once the substrate table has arrived at the substrate loading system SL such that the substrate W may be lifted from the substrate table WT1 by a substrate handler. That is, the substrate W is no longer clamped to the substrate table WT1.

During loading of a substrate onto the substrate table WT1 (and unloading), the voltage sources 50, 52 and the current source 54 may all be set to 0V.

The above described method may be used in connection with a substrate table according to any embodiment of the invention.

The use of doped diamond as the resistive layer 30 is particularly advantageous. This is because diamond has material properties (which may be referred to as tribology) which are desirable for a substrate table WT1. In particular, diamond is extremely hard wearing, and thus is not abraded over time by substrates. This is advantageous because abrasion of a surface will generate particulate contamination, and particulate contamination is not desirable in a lithographic apparatus.

The resistivity of the doped diamond resistive layer 30 may be selected as desired via the amount of doping which is provided in the diamond. As noted further above the dopant may be Boron. Using a dopant to obtain a desired resistance advantageously does not have a significant effect upon the tribology of the diamond (the tribology is determined by the diamond). This is because the percentage of the dopants is very small compared to the carbon atoms percentage. The tribology is determined by the crystal structure of the diamond, and the dopant does not have a significant effect on this.

It may be desirable to have a resistance which is sufficiently high that a high leakage current through the resistive layer 30 is avoided. This is because a high leakage current could undesirably cause significant heating of the substrate and/or could damage the substrate (e.g. if the substrate had a conductive lowermost surface). Conversely, since the Johnsen-Rahbek clamping force arises from charge accumulation at the upper surface of the resistive layer 30, it may be desirable that the resistance of the resistive layer is not so high that it takes too long for current to accumulate on the upper surface of the resistive layer and provide clamping force.

The doped resistive layer 30 may for example have a resistivity between 10¹³ Ohm cm and 10⁶ Ohm cm. The doped resistive layer 30 may for example have a resistivity of around 10⁸ Ohm cm.

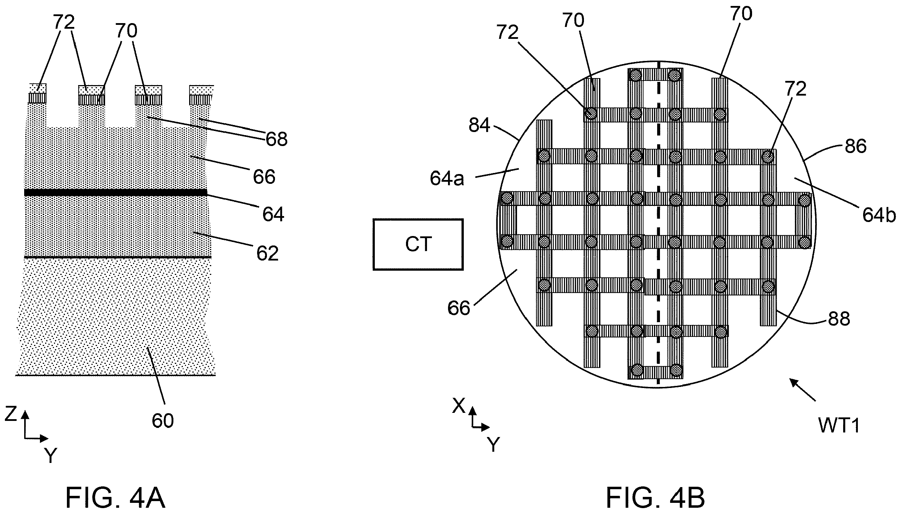

Figure 4 schematically depicts a substrate table WT1 comprising a substrate clamp according to an alternative embodiment of the invention. Figure 4A schematically depicts part of the substrate clamp in cross-section, and Figure 4B schematically depicts the substrate clamp viewed from above. The substrate clamp comprises a layer of ceramic such as SiSiC 60. On top of the ceramic layer 60 a layer of dielectric 62 is provided. The dielectric may for example be glass, or any other insulator. An electrode 64 is located on top of the dielectric layer 62. A further dielectric layer 66, which may also be glass or any other insulator, is provided on top of the electrode 64. The dielectric layer 66 includes burls 68 provided in an array (as with the embodiment depicted in Figures 2 and 3). In Figure 4B two electrodes 64a,b are labelled, separated by a dashed line, although the electrodes are beneath the further dielectric layer 66 and so are not visible.

Electrically conductive material 70, e.g. CrN is deposited onto the further dielectric layer 66 (which may be referred to as the upper dielectric layer 66) in a grid-like arrangement. The electrically conductive material 70 extends between the burls 68 and passes over tops of the burls. The burls are thus electrically connected by the electrically conductive material 70. The electrically conductive material may for example have a thickness of between 100nm and 10 microns. A resistive layer 72 is provided on top of the electrically conductive material 70 on each burl 68. The resistive layer 72 may be formed for example from diamond which has been doped, e.g. with Boron. The resistive layer 72 may for example have a thickness of between 100nm and 10 microns.

The concentration of the dopant may be selected to provide the resistive layers 72 with a desired resistance. The resistive layer 72 may for example have a resistivity between 10¹³ Ohm cm and 10⁶ Ohm cm. The resistive layer 72 may for example have a resistivity of around 10⁸ Ohm cm.

In an embodiment, the substrate clamp may include additional layers beneath the ceramic layer 60. For example, the structure depicted in Figure 4 may be made two times, one of the structures being inverted and then bonded to the other structure. The lowermost resistive material which provides Johnsen-Rahbek clamping may be omitted from the lowermost structure. The lowermost electrically conductive material may be retained.

The substrate table WT1 may include further layers, such as a support layer (not depicted).

Two voltage sources 84, 86 are connected to the first and second electrodes 64a,b. A current source 88 is connected to the electrically conductive material 70. The current source 88 may be an amplifier that controls both current and voltage. A controller CT controls operation of the voltage and current sources 84, 86, 88. These may be located within the substrate table WT1.

The first and second electrodes 64a,b form an electrostatic clamp. The electrically conductive material 70 and resistive layers 72 form a Johnsen-Rahbek clamp. The substrate table WT1 thus comprises a Johnsen-Rahbek clamp and an electrostatic clamp.

The base of the Johnsen-Rahbek clamp has been described and depicted in Figure 3 as being a single entity to which a single current is applied. Similarly, in Figure 4, the electrically conductive material 70 is interconnected to form a single conductor to which a single current is applied. However, in other embodiments the Johnsen-Rahbek clamp may be provided as two or more electrically isolated entities.

In embodiments in which the Johnson-Rahbek clamp includes a conductive base, the two or more electrically isolated parts of the base may be structurally connected to form a rigid support for the substrate. The arrangement of the parts of the Johnsen-Rahbek clamp may for example be two semicircles, in a manner which corresponds with that depicted in Figure 3 for the electrostatic clamp. Other configurations of two parts of the Johnsen-Rahbek clamp may be provided.

In embodiments in which the Johnson-Rahbek clamp includes lines of connected conductive material, gaps may be provided between the conductive material along a central line of the clamp. For example, gaps may be provided where the dashed line is shown in Figure 4B. Other configurations of two or more parts of the Johnsen-Rahbek clamp may be provided.

Preferably, when the Johnsen-Rahbek clamp is provided in two parts, the number of burls in each half of the Johnsen-Rahbek clamp are the same.

The Johnsen-Rahbek clamp and the electrostatic clamp may have different arrangements. For example, a separation between two halves of the electrostatic clamp may extend in the Y-direction and separation between two halves of the Johnsen-Rahbek clamp may extend in the X-direction (Cartesian coordinates are included in the Figures for ease of description and understanding). In embodiments in which the Johnsen-Rahbek clamp is provided in two parts, these parts may be provided with opposite polarities in order to minimise charge accumulation over time. Where this is the case, it may be desirable to provide the resistive layer 30, 72 with sufficient resistance to avoid substantial current flow between oppositely charged parts of the Johnsen-Rahbek clamp (i.e. via the substrate).

In an embodiment, the resistivity of the resistive layers 30, 72 may be at least 10⁶ Ohm cm. The resistivity of the resistive layers 30, 72 may be up to 10¹³ Ohm cm. The resistivity of the resistive layers 30, 72 may for example be around 10⁸ Ohm cm.

In an embodiment, the voltage source may be disconnected from the Johnsen-Rahbek clamp before exposure of the substrate W has been completed. This may be done if sufficient time is not available after exposure of the substrate has been completed to allow the Johnsen-Rahbek force to be sufficiently reduced such that the substrate can be removed from the substrate table.

In a conventional dual stage lithographic apparatus, a substrate may be removed from a substrate table WT1, WT2 as soon as the substrate table has arrived at the substrate loading system, and once the substrate has been removed a new substrate for exposure may be immediately placed upon the substrate table. In this conventional method, measurement of properties of the newly loaded substrate may be completed before exposure of a substrate is completed. As a result, there may be a pause during which the measured substrate is no longer being measured but instead is merely waiting until exposure of the substrate being exposed has been completed, so that the measured substrate can at that time be moved to be beneath the projection system PS of the lithographic apparatus. If the time taken for measurement of the substrate is significantly shorter than the time taken for exposure of the substrate, such that there will be a pause of the measured substrate before it can be exposed, this pause may be instead imposed at the point in time when the substrate table arrives at the substrate loading system SL for unloading. That is, available time which would otherwise not be used during measurement of the substrate may be used to allow further discharge of the Johnsen-Rahbek clamp before the substrate is removed from the substrate table. The pause may for example be 1 second or less.

Embodiments of the invention may provide clamping force at the burls arising from the Johnsen-Rahbek effect and may in addition provide electrostatic clamping at areas which are between the burls. Thus, clamping force may be applied across substantially an entire substrate which is held on the substrate table WT1, WT2.

Although embodiments of the invention have been described in connection with a substrate and substrate tables, in other embodiments the invention may be used to clamp a mask MA (or other patterning device) to a support structure MT of a lithographic apparatus (see Figure 1), or to clamp some other object. In general, embodiments of the invention may be used to clamp an object. The table of embodiments of the invention may be referred to as an object table.

A voltage of around 3kV (or more) may be applied to the conductor(s) of the electrostatic clamp. A voltage of less than 250V may be applied to the Johnsen-Rahbek clamp. The voltage applied to the Johnsen-Rahbek clamp may be less than 10V, e.g. as little as 3V.

Embodiments of the invention generally relate to a combination of an electrostatic clamp, and a clamp with an array of electrically connected burls, the burls comprising a layer of resistive material at an object receiving surface of the burls.

In a more general sense, embodiments of the invention relate to an object table comprising two clamps which use different clamping mechanisms. The first clamping mechanism may be electrostatic with the second clamping mechanism being Johnsen-Rahbek type clamping. Alternatively, the first clamping mechanism may be vacuum with the second clamping mechanism being electrostatic. Other combinations of clamping mechanism may be used.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference has been made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions. A substrate clamp according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Example

1. A lithographic method performed using a dual stage lithographic apparatus, the method comprising:
   a. placing a substrate on a substrate table comprising an electrostatic clamp and a Johnsen-Rahbek clamp;
   b. supplying electrical power to the electrostatic clamp and the Johnsen-Rahbek clamp;
   c. moving the substrate table to a measurement system of a dual stage lithographic apparatus then measuring properties of the substrate whilst charge accumulates on the Johnsen-Rahbek clamp; and
   d. moving the substrate table to a projection system of the dual stage lithographic apparatus, and using the projection system to project a pattern onto the substrate.

## Claims

1. An object table comprising:
an electrostatic clamp which comprises at least one electrode provided between insulating layers; and
a second clamp which comprises an array of electrically connected burls, the burls comprising a layer of resistive material at an object receiving surface of the burls.

2. The object table of claim 1, where in the second clamp is a Johnsen-Rahbek type clamp.

3. The object table of claim 1 or claim 2, wherein the resistive material is doped diamond.

4. The object table of claim 3, wherein the resistive material is diamond doped with Boron.

5. The object table of any preceding claim, wherein the layer of resistive material has a resistivity of at least 10⁶ Ohm cm or/and wherein the layer of resistive material has a thickness of at least 100nm.

6. The object table of any preceding claim, wherein the electrostatic clamp is provided with an array of openings, and wherein the burls are formed from electrically conductive material and extend through the openings.

7. The object table of claim 5, wherein the burls are integrally formed with an electrically conductive body, and wherein the electrostatic clamp is fixed to the electrically conductive body.

8. The object table of claim 6, wherein the electrically conductive body is provided with annular recesses which surround the burls.

9. The object table of any of claims 5 to 7, wherein the electrically conductive body comprises flat portions located between the burls, the flat portions receiving the electrostatic clamp.

10. The object table of any of claims 1 to 5, wherein electrically conductive material is provided on top of the electrostatic clamp, the electrically conductive material extending over the burls and electrically connecting the burls.

11. The object table of any preceding claim, wherein the electrostatic clamp comprises two electrodes provided between insulating layers, the electrodes being electrically isolated from each other or/and wherein the Johnsen-Rahbek clamp comprises two electrically conductive parts, the electrically conductive parts being electrically isolated from each other.

12. A lithographic apparatus comprising an illumination system and a projection system, and further comprising an object table according to any preceding claim.

13. The lithographic apparatus of claim 11, wherein the lithographic apparatus is a dual stage lithographic apparatus and wherein two object tables are provided, the two object tables being according to any preceding claim.

14. A semiconductor manufacturing tool, wherein the tool further comprises an object table according to any of claims 1 to 11.

15. An object table comprising a first clamp configured to clamp an object using a first clamping mechanism and a second clamp configured to clamp an object using a second clamping mechanism.
